# EUROPEAN PATENT SPECIFICATION

(11) **EP 4 057 362 B1**
(45) Date of publication and mention of the grant of the patent: **30.09.2026**
(21) Application number: 20886020.5
(22) Date of filing: 04.11.2020
(51) Int. Cl.: H10P 72/00, H10P 72/30, H10F 71/00

(54) **SOLAR CELL CURING AND HYDROGEN PASSIVATION INTEGRATED MACHINE**
INTEGRIERTE MASCHINE FÜR SOLARZELLENHÄRTUNG UND WASSERSTOFFPASSIVIERUNG
MACHINE INTÉGRÉE DE DURCISSEMENT ET DE PASSIVATION PAR HYDROGÈNE DE CELLULE SOLAIRE

(30) Priority: 04.11.2019 CN 201911063680
(43) Date of publication of application: 14.09.2022
(73) Proprietor: Suzhou N-Single Intelligent Technology Co., Ltd., Suzhou, Jiangsu 215000 (CN)
(72) Inventor: WANG, Hui, Suzhou, Jiangsu 215000 (CN); TAN, Jianhui, Suzhou, Jiangsu 215000 (CN); DAI, Xiangrong, Suzhou, Jiangsu 215000 (CN)
(74) Representative: Bryers Intellectual Property Ltd
(86) International application number: PCT/CN2020/126333
(87) International publication number: WO 2021/088836

(56) References cited:
- CN-A- 104 810 309
- CN-A- 110 707 180
- CN-A- 111 735 299
- CN-U- 204 537 995
- CN-U- 204 668 333
- CN-U- 210 349 859
- US-A1- 2013 189 635
- US-A1- 2018 010 856
- US-B2- 8 039 051

## Description

### Technical Field of the Invention

The present disclosure relates to the technical field of solar cell production, in particular to a solar cell curing and hydrogen passivation integrated machine.

### Background of the Invention

After the solar cells are manufactured, they need to be dried and cured through a curing furnace, and then through a hydrogen passivation furnace for hydrogen passivation. In the prior art, the curing furnace for curing solar cells and the hydrogen passivation furnace for hydrogen passivation are independently installed, in this way, after the solar cells are cured in the curing furnace, the solar cells need to be transported by a transport mechanism to a hydrogen passivation furnace for hydrogen passivation treatment. The process steps are complicated, continuous production cannot be realized, and the production efficiency is low; moreover, the solar cells are prone to damage during the transportation process, thereby affecting the quality of the solar cells.

US8039051B2 discloses a method and apparatus for hydrogenation of a target, such as a polycrystalline silicon film on a glass substrate, by using an atomic hydrogen source. The target is subjected to intermittent exposure of the atomic hydrogen field of the source until at least one area of the target has been subjected to the hydrogen field for a predetermined minimum period of time. The processing area of the source established by its atomic hydrogen field is smaller than the target, and after the target is moved into the high temperature processing zone it is translated within the high temperature processing zone to intermittently process successive areas of the target until the entire target has been processed for a predetermined minimum period of time. After the entire target has been processed, the target is cooled to a predetermined lower temperature while still intermittently subjecting the target to atomic hydrogen.
US20130189635A1 discloses a method and apparatus for heat treating a photovoltaic device. The apparatus includes a heating module, a processing module, and a cooling module in which the operating temperatures of the modules may be controlled separately. The heating module is configured to pre-heat a substrate and stabilize the substrate at the desired target temperature, the processing module is configured to thermally process the substrate, and the cooling module is configured for post-treatment cooling of the substrate.

### Summary of the Invention

The purpose of the present disclosure is to provide an improved solar cell curing and hydrogen passivation integrated machine in view of the problems in the prior art.

To achieve the above purpose, the technical solution employed by the present disclosure is:
a solar cell curing and hydrogen passivation integrated machine, comprises a rack, a curing furnace adapted for carrying out curing treatment on solar cells, a hydrogen passivation furnace adapted for carrying out hydrogen passivation treatment on the solar cells, and a conveying device adapted for conveying the solar cells, the curing furnace and the hydrogen passivation furnace are sequentially arranged on the rack, one end portion of the curing furnace outputting pieces is adjacent to one end portion of the hydrogen passivation furnace intaking pieces, the conveying device is continuously arranged on the rack, and the conveying device respectively passes through the curing furnace and the hydrogen passivation furnace;
   the hydrogen passivation furnace comprises an optical module, an electrical module, and a temperature control system for controlling the temperature in the furnace cavity of the hydrogen passivation furnace, the optical module, the electrical module and the temperature control system are all arranged on the rack, the optical module and the electrical module are connected by a line, and the temperature control system comprises a control box arranged on the rack and located at the bottom of the optical module, a heating unit arranged in the control box, and a cooling unit arranged on the control box;
   the optical module comprises a light source box arranged on the rack, a plurality of independently controllable light source devices arranged on the light source box, and a plurality of condensing lens devices covering outside the light-emitting surfaces of the light source devices, and each light source device provides at least one unit of light intensity;
the optical module further comprises a first cooling device for cooling light-emitting back sides of the light source devices and/or a second cooling device for cooling light-emitting front sides of the light source devices, the first cooling device is a water-cooling unit, and the second cooling device is a wind cooling unit.

Preferably, the curing furnace comprises a heating module for heating and curing solar cells, and a waste discharge device and a combustion tower arranged on the top of the heating module, the heating module is arranged on the rack, the top of the heating module is provided with waste discharge ports, the combustion tower and the waste discharge device are respectively connected to different waste discharge ports, the heating module has a heating chamber, the heating chamber comprises a plurality of unit heating chambers arranged side by side, the temperature of each of the unit heating chambers can be independently controlled, and the conveying device passes through each of the unit heating chambers.

Further, the heating module comprises an upper heating module and a lower heating module, the upper heating module and the lower heating module are both arranged on the rack in a manner of being able to be raised and lowered up and down.

Preferably, the conveying device comprises a plurality of conveying rollers rotatably arranged on the rack and a driving device arranged on the rack for driving the rotation of the conveying rollers, and the plurality of the conveying rollers is arranged in parallel, and the driving device comprises a transmission shaft rotatably arranged on the rack, a driving wheel fixedly arranged on the transmission shaft, and a driven wheel fixedly arranged on one end portion of each of the conveying rollers, and a motor for driving the transmission shaft to rotate, the driving device further comprises a transmission mechanism that is arranged between the driven wheel and the driving wheel and drives the driven wheel to rotate when the driving wheel rotates, and the transmission mechanism is a magnetic transmission mechanism, a belt transmission mechanism or a gear transmission mechanism.

Preferably, the conveying device comprises a plurality of conveying rollers rotatably arranged on the rack, each of the conveying rollers is provided with a positioning structure for positioning solar cells at the same axial position, the positioning structure comprises a recess portion arranged on each conveying roller and two positioning portions at two ends of the recess portion, and the solar cells are located in the recess portion, and are limited by the positioning portions on their opposite sides.

Preferably, the integrated machine further comprises a third cooling device arranged on the rack, the third cooling device is arranged on the rack close to the end portion of the hydrogen passivation furnace in the outputting direction, the third cooling device comprises a cooling box arranged on the rack and a cooling fan arranged on the cooling box, the cooling box has a cooling chamber, the conveying device passes through the cooling chamber, the cooling box is provided with an air inlet and an air outlet, the air inlet and the air outlet are respectively located above and below the conveying device, the cooling fan is arranged at the air inlet, the cooling box is provided with a confluence area with a tapered structure, and the air outlet is arranged at a small end of the confluence area.

Due to the use of the above technical solutions, the present disclosure has the following advantages over the prior art: the solar cell curing and hydrogen passivation integrated machine is simple in structure; the solar cells can be directly conveyed to the hydrogen passivation furnace through the conveying device to be subjected to hydrogen passivation treatment after being cured in the curing furnace, the technological process is continuous, the technological step of carrying the solar cells is omitted, and damage caused by carrying the solar cells can be avoided while the production efficiency is improved.

### Brief Description of the Drawings

Figure 1 is a schematic structure diagram of the solar cell curing and hydrogen passivation integrated machine of the present disclosure (the electrical module of the hydrogen passivation furnace is omitted);
Figure 2 is a schematic structure diagram of the curing furnace of the solar cell curing and hydrogen passivation integrated machine of the present disclosure;
Figure 3 is a partial enlarged view of Part A in Figure 2;
Figure 4 is a schematic structure diagram of the hydrogen passivation furnace and the third cooling device of the solar cell curing and hydrogen passivation integrated machine of the present disclosure (part of the rack is omitted);
Figure 5 is a partial enlarged view of Part A in Figure 4;
Figure 6 is a schematic structure diagram of the optical module of the solar cell curing and hydrogen passivation integrated machine of the present disclosure;
Figure 7 is a schematic structure diagram of the temperature control system of the solar cell curing and hydrogen passivation integrated machine of the present disclosure (one sidewall is omitted).

### Detailed Description of Exemplary Embodiments

In the following, the technical solution of the present disclosure is further described combining with the accompanying drawings.

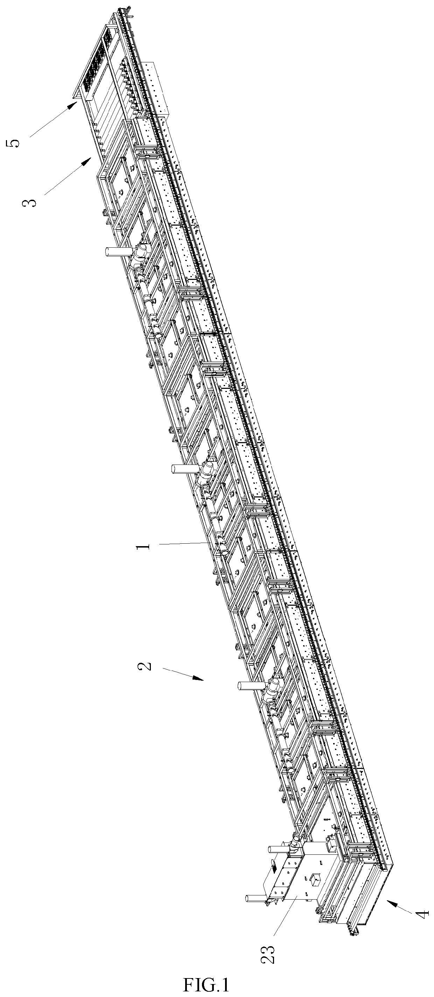

As shown in Figure 1, a solar cell curing and hydrogen passivation integrated machine of the present disclosure comprises a rack 1, a curing furnace 2 used for carrying out curing treatment on solar cells, a hydrogen passivation furnace 3 used for carrying out hydrogen passivation treatment on the solar cells, and a conveying device 4 used for conveying the solar cells, the curing furnace 2 and the hydrogen passivation furnace 3 are sequentially arranged on the rack 1, one end portion of the curing furnace 2 outputting pieces is adjacent to one end portion of the hydrogen passivation furnace 3 intaking pieces, the conveying device 4 is continuously arranged on the rack 1, and the conveying device 4 respectively passes through the curing furnace 2 and the hydrogen passivation furnace 3.

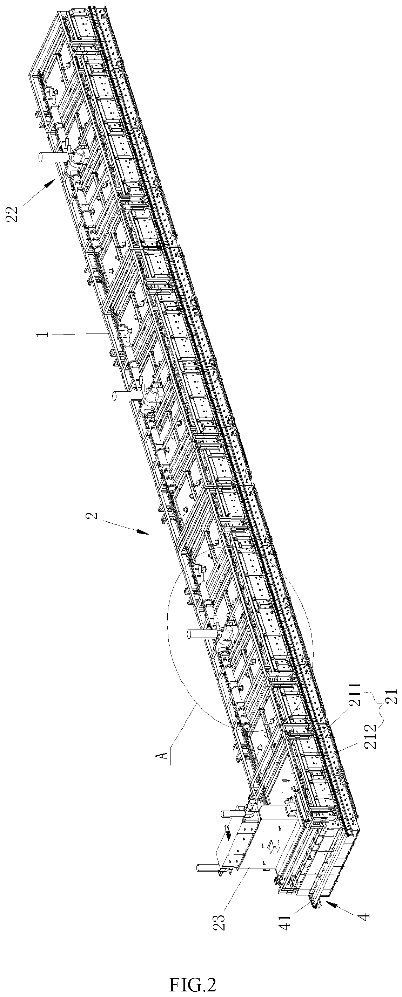

As shown in Figure 2, the curing furnace 2 comprises a heating module 21, a waste discharge device 22 and a combustion tower 23, the heating module 21 is used to heat and cure solar cells, the waste discharge device 22 is used to extract waste gas generated in the heating module 21, the combustion tower 23 is used to burn the waste gas generated in the heating module 21, the heating module 21 is arranged on the rack 1, and the waste discharge device 22 and the combustion tower 23 are arranged on the top of the heating module 21.

The heating module 21 comprises an upper heating module 211 and a lower heating module 212 arranged on the rack 1, the conveying device 4 is arranged between the upper heating module 211 and the lower heating module 212, and the upper heating module 211 and the lower heating module 212 are fastened to form a heating chamber between the upper heating module 211 and the lower heating module 212. The heating chamber is partitioned into a plurality of unit heating chambers, the temperature of each of the unit heating chambers can be independently controlled, so that the temperature control accuracy of the heating module 21 can be improved, and the drying effect of the solar cells can be improved to improve the quality of the solar cells.

Each unit heating chamber is provided with a plurality of heating elements, and each heating element can be independently controlled, so as to realize independent control of the heating temperature in each unit heating chamber. In this embodiment, the heating element can be one or more of a heating tube, a heating rod, and a heating wire.

The heating module 21 further comprises hot air circulation devices respectively arranged in the respective unit heating chambers, the hot air circulation devices allow the hot air to flow in the respective unit heating chambers, thereby making the temperature distribution in the respective unit heating chambers more uniform.

The heating module 21 further comprises a heat preservation device arranged on the sidewall of the heating chamber, in this embodiment, the heat preservation device is provided on the sidewalls of the upper heating module 211 and the lower heating module 212, and the heat preservation device may adopt heat preservation cotton arranged on the sidewalls of the upper heating module 211 and the lower heating module 212. The heat preservation device can ensure the stability of the temperature in the heating chamber, thereby ensuring the drying effect of the solar cells.

The upper heating module 211 and the lower heating module 212 are both arranged on the rack 1 in a manner of being able to be raised and lowered up and down, and the curing furnace 2 further comprises a first driving device for driving the upper heating module 211 to rise up and lower down and a second driving device for driving the lower heating module 212 to rise up and lower down, the first driving device and the second driving device are both arranged on the rack 1, and the first driving device and the second driving device can both be independently controlled, and the upper heating module 211 is arranged on the first driving device, and the lower heating module 212 is arranged on the second driving device, so that the upper heating module 211 and the lower heating module 212 can be raised and lowered independently, which facilitates the operator to clean up the debris of the solar cells that have fallen into the lower heating module 212, and facilitates the maintenance operation of the integrated machine. Of course, the upper heating module 211 and the lower heating module 212 can also be fixedly arranged on the rack 1.

The top of the upper heating module 211 is provided with waste discharge ports, as shown in Figures 1 to 3, each waste discharge device 22 comprises a main pipe 221 and a plurality of branch pipe assemblies 222, and one end portion of each branch pipe assembly 222 is respectively connected to one waste discharge port, and the other end of each branch pipe assembly 222 is connected to the main pipe 221. The waste discharge device 22 further comprises an exhaust device 223 which is connected to the main pipe 221. The exhaust device 223 is used to extract the high-temperature waste gas in the heating chamber into each branch pipe assembly 222, and then collect it in the main pipe 221, and finally discharge it outside the waste discharge device 22 for treatment, such waste discharge method can make the waste discharge more thorough. In this embodiment, the exhaust device 223 adopts a centrifugal fan.

The main pipe 221 and/or each branch pipe assembly 222 is further provided with a regulating valve 224, the opening and closing of the regulating valve 224 and the degree of opening of the regulating valve 224 may control the discharge volume of the waste discharge device 22, so that the temperature inside the heating module 21 is kept balanced.

The bottom of the combustion tower 23 is provided with a gas inlet, the gas inlet is connected to the waste discharge port of the top of the heating module 21, the combustion tower 23 is located at an end portion of the heating module 21 in the intaking direction of the curing furnace 2, that is to say, the waste gas generated in the initial heating stage in the heating module 21 first enters the combustion tower 23 for combustion, this is because the waste gas generated in the initial heating stage of the heating module 21 contains more particulate waste gas, and the waste gas is fully burned in the combustion tower 23 and then discharged to the outside, which can reduce environmental pollution, while in the subsequent heating of the heating module 21, the content of pollutants in the generated waste gas is less, and the waste gas can be directly discharged to the outside through the waste discharge device 22.

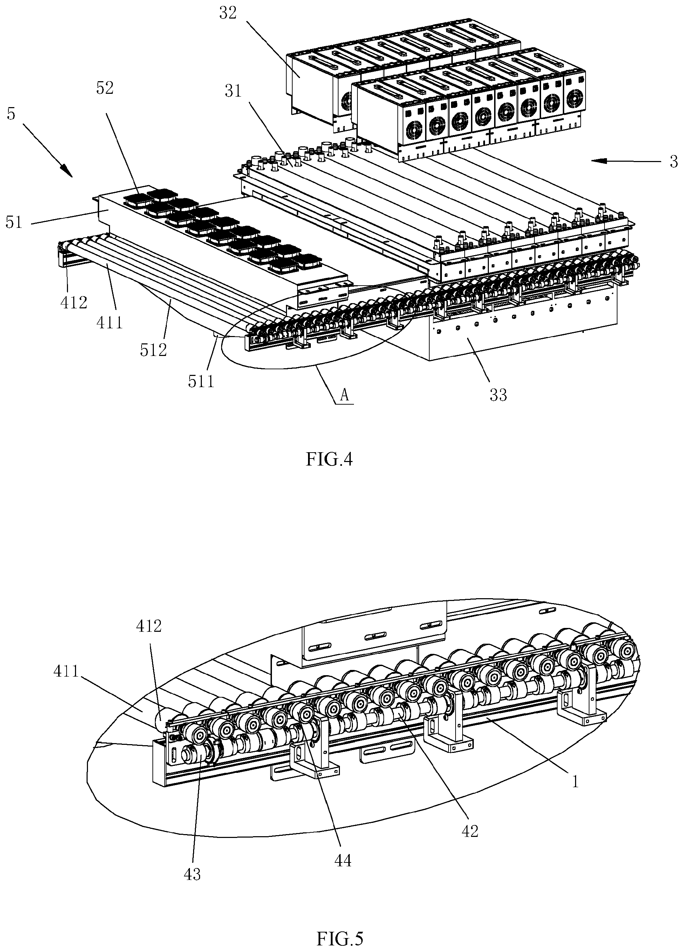

As shown in Figure 4, the hydrogen passivation furnace 3 comprises an optical module 31 and an electrical module 32, the optical module 31 and the electrical module 32 are both arranged on the rack 1, the optical module 31 and the electrical module 32 are connected by a line, and the electrical module 32 is used to provide electrical energy to the optical module 31.

The optical module 31 comprises a light source box 311 arranged on the rack 1, a light source backplane arranged in the light source box 311, and a plurality of independently controllable light source devices arranged on the light source backplane, each light source device provides at least 1 unit of light intensity, and the light-emitting front side of the light source faces towards the conveying device 4. In this embodiment, the light source box 311 is of a U-shape structure with an opening downward, the plurality of light source devices is arranged in a matrix form, and is LED light sources.

The optical module 31 further comprises a plurality of condensing lens devices covering outside the light-emitting surfaces of the light source devices, preferably, the light-emitting surface of each light source device is covered with one condensing lens device. The condensing lens devices can adjust the angle of the light emitted by the light source devices, thereby increasing the light intensity, thereby improving the hydrogen passivation effect of the solar cells.

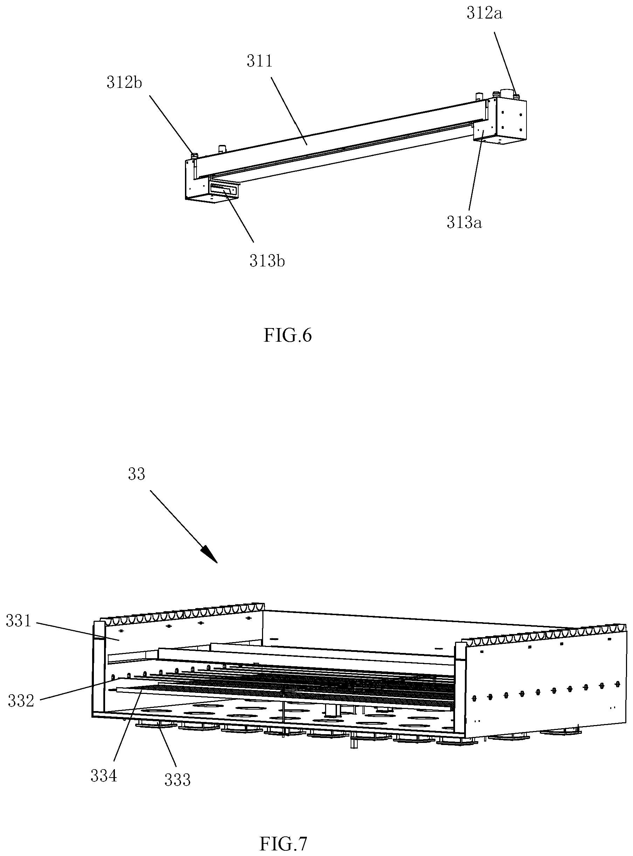

As shown in Figure 6, the optical module 31 further comprises a first cooling device for cooling light-emitting back sides of the light source devices. In this embodiment, the first cooling device adopts a water cooling device, specifically, this water cooling device comprises a cooling water tank, a water inlet pipe 312a, and a water outlet pipe 312b, the cooling water tank is located in the light source box 311 and arranged on the light source backplane, meanwhile, the cooling water tank is arranged on the light-emitting back sides of the light source devices, the cooling water tank is provided with a water inlet and a water outlet, one end portion of the water inlet pipe 312a is connected to the water inlet, and the other end portion extends to the outside of the light source box 311, and one end portion of the water outlet pipe 312b is connected with the water outlet, and the other end extends to the outside of the light source box 311. The cooling water tank is further provided with a water flow channel for the cooling water to flow. The light source backplane is cooled by providing a water-cooling device to prolong its service life.

As shown in Figure 6, the optical module 31 further comprises a second cooling device for cooling light-emitting front sides of the light source devices. In this embodiment, the second cooling device adopts an air cooling device, specifically, the air cooling device comprises an air knife arranged within the light source box 311, an air inlet channel 313a and an air outlet channel 313b, the air inlet channel 313a and the air outlet channel 313b are respectively located at opposite ends of the light source box 311in the length direction, the air outlet channel 313b is provided with an exhaust blower, two ends of the air inlet channel 313a are respectively connected with an air compressor and the air knife, and the wind from the air knife cools the solar cells. By providing the air-cooling device, the air on the light-emitting front sides of the light source devices can be circulated, so that the temperature of the light-emitting surfaces of the light source devices can be reduced, and the service life of the light source device can be prolonged.

The hydrogen passivation furnace 3 further comprises a temperature control system 33 arranged on the rack 1, the temperature control system 33 is used to adjust the temperature in the furnace cavity of the hydrogen passivation furnace 3, in this embodiment, the temperature control system 33 is provided at the bottom of the light source box 311 and below the conveying device 4. The temperature control system 33 comprises a control box 331 arranged on the rack 1, a heating unit 332 arranged in the control box 331, and a cooling unit 333 arranged on the control box 331, and an end portion of the control box 331 faces the conveying device 4 is open. When the temperature in the furnace cavity of the hydrogen passivation furnace 3 is lower than the set temperature during the hydrogen passivation process, the heating unit 332 is activated to increase the temperature in the furnace cavity of the hydrogen passivation furnace 3; when the temperature in the furnace cavity of the hydrogen passivation furnace 3 is higher than the set temperature, the cooling unit 333 is activated to reduce the temperature in the furnace cavity of the hydrogen passivation furnace 3. In this embodiment, the heating unit 332 may be a heating wire or a heating tube, and the cooling unit 333 may be a cooling fan.

As shown in Figure 7, the temperature control system 33 further comprises a mesh plate 334 arranged in the control box 331, the bottom of the control box 331 is provided with an air inlet, the cooling unit 333 is arranged at the air inlet, and the mesh plate 334 is located between the heating unit 332 and the bottom of the control box 331, the mesh plate 334 is provided with a plurality of meshes penetrating the upper and lower end faces of the mesh plate 334, and by providing the mesh plate 334, the temperature distribution in the control box 331 can be more uniform.

As shown in Figures 1 to 5, the conveying device 4 comprises a plurality of conveying rollers 41 arranged in parallel at intervals, each of the conveying rollers 41 can be arranged to rotate in the same direction around its own axis, the solar cells are placed on the conveying rollers 41, and when the plurality of conveying rollers 41 is rotated in the same direction, the solar cells are conveyed forward.

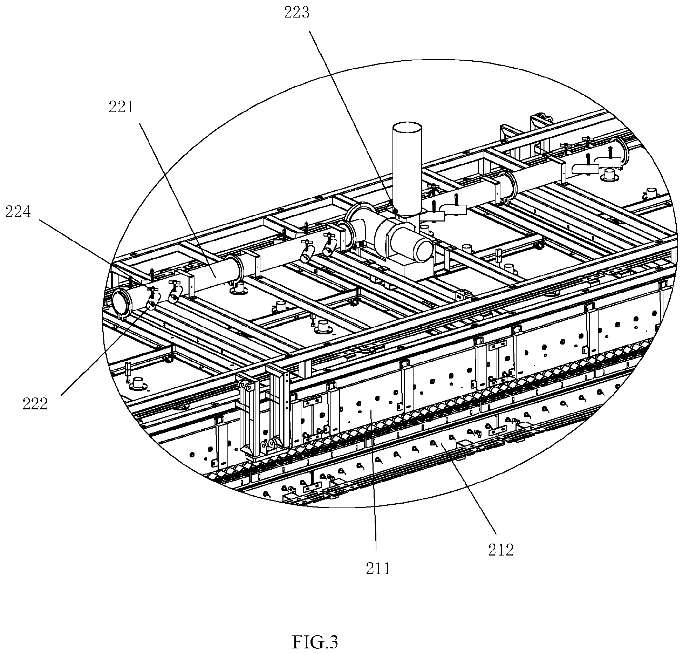

The conveying device 4 further comprises a driving device for driving the rotation of the respective conveying rollers 41, as shown in Figure 3, the driving device comprises a transmission shaft 42 rotatably arranged on the rack 1, driving wheels 43 fixedly arranged on the transmission shaft 42, and driven wheels 44 fixedly arranged on one end portion of each of the conveying rollers 41, and a motor for driving the transmission shaft 42 to rotate, and the driving device further comprises a transmission mechanism that is arranged between the driven wheel 44 and the driving wheel 43 and drives the driven wheel 44 to rotate when the driving wheel 43 rotates, and the transmission mechanism may employ a magnetic transmission mechanism, a belt transmission mechanism or a gear transmission mechanism. The shaft axis of the driving wheel 43 is perpendicular or parallel to the shaft axis of the driven wheel 44.

As shown in Figure 1, Figure 2, Figure 4 and Figure 5, each conveying roller 41 is provided with a positioning structure for positioning the solar cell at the same axial position, and by the provision of the positioning structure, the linear transmission of solar cells during the transmission process can be ensured, position deviation is avoided, and the transmission accuracy of solar cells is improved.

The positioning structure comprises a recess portion 411 arranged on each conveying roller 41 and two positioning portions 412 at two ends of the recess portion 411, the solar cells are located in the recess portion 411, and the opposite sides thereof are limited by the positioning portions 412 on the two sides of the recess portion 411.

The solar cell curing and hydrogen passivation integrated machine further comprises a third cooling device 5 arranged on the rack 1, and the third cooling device 5 is located on the rack 1 close to the end portion of the hydrogen passivation furnace 3 in the outputting direction. Specifically, as shown in Figure 1 and Figure 4, the third cooling device 5 comprises a cooling box 51 arranged on the rack 1 and a cooling fan 52 arranged on the cooling box 51, the cooling box 51 has a cooling chamber, the conveying device 4 passes through the cooling chamber, the cooling box 51 is provided with an air inlet and an air outlet 511, the air inlet and the air outlet 511 are respectively located above and below the conveying device 4, the cooling fan 52 is arranged at the air inlet, the cooling box 51 is provided with a confluence area 512 with a tapered structure, and the air outlet 511 is arranged at a small end of the confluence area 512. When the third cooling device 5 is activated, the cooling fan 52 is rotated, sucking the cold air outside the third cooling device 5 into the cooling chamber from the air inlet, and blowing it to the solar cells, thereby cooling the solar cells; the air flow after cooling the solar cells is collected at the confluence area 512, and then is discharged to the outside of the third cooling device 5 through the air outlet 511.

During the solar cell manufacturing process, the solar cells are first transferred to the heating module 21 of the curing furnace 2 through the conveying device 4 for heating and curing, the waste gas generated by the heating module 21 in the heating and curing process is discharged from the combustion tower 23 and the waste discharge device 22 to the outside of the curing furnace 2; after the curing process is completed, the solar cells are directly transferred by the conveying device 4 to the hydrogen passivation furnace 3 for hydrogen passivation treatment, and during the hydrogen passivation process, the temperature during the hydrogen passivation treating process is controlled by controlling the heating unit 332 and the cooling unit 333 in the temperature control system 33, and the light intensity during the hydrogen passivation treating process is controlled by controlling the light source devices to meet the temperature and light requirements during the hydrogen passivation process, so as to improve the hydrogen passivation effect of solar cells, thereby improving the power generation efficiency of solar cells; after the hydrogen passivation treatment is completed, the solar cells are transferred by the conveying device 4 to the third cooling device 5 for cooling, so as to reduce the temperature of the solar cells.

The solar cell curing and hydrogen passivation integrated machine is simple in structure, the solar cells can be directly conveyed to the hydrogen passivation furnace through the conveying device to be subjected to hydrogen passivation treatment after being cured in the curing furnace, the technological process is continuous, the technological step of carrying the solar cells is omitted, which can improve the production efficiency, thereby increasing production capacity; and it can also avoid damage to the solar cells during the carrying process, which affects the quality of the solar cells.

The invention is defined by the appended claims.

## Claims

1. A solar cell curing and hydrogen passivation integrated machine, comprising a rack (1), a curing furnace (2) adapted for carrying out curing treatment on solar cells, a hydrogen passivation furnace (3) adapted for carrying out hydrogen passivation treatment on the solar cells, and a conveying device (4) adapted for conveying the solar cells, the curing furnace (2) and the hydrogen passivation furnace (3) are sequentially arranged on the rack (1), one end portion of the curing furnace (2) outputting pieces is adjacent to one end portion of the hydrogen passivation furnace (3) intaking pieces, the conveying device (4) is continuously arranged on the rack (1), and the conveying device (4) respectively passes through the curing furnace (2) and the hydrogen passivation furnace (3);
the hydrogen passivation furnace (3) comprises an optical module (31), an electrical module (32), and a temperature control system (33) for controlling the temperature in the furnace cavity of the hydrogen passivation furnace (3); the optical module (31), the electrical module (32) and the temperature control system (33) are all arranged on the rack (1), the optical module (31) and the electrical module (32) are connected by a line,
is **characterized in that**,
the temperature control system (33) comprises a control box (331) arranged on the rack (1) and located at the bottom of the optical module (31), a heating unit (332) arranged in the control box (331), and a cooling unit (333) arranged on the control box (331);
the optical module (31) comprises a light source box (311) arranged on the rack (1), a plurality of independently controllable light source devices arranged on the light source box (311), and a plurality of condensing lens devices covering outside the light emitting surfaces of the light source devices, and each light source device provides at least one unit of light intensity;
the optical module (31) further comprises a first cooling device for cooling light-emitting back sides of the light source devices and/or a second cooling device for cooling light-emitting front sides of the light source devices, the first cooling device is a water-cooling unit, and the second cooling device is a wind cooling unit.

2. The solar cell curing and hydrogen passivation integrated machine according to claim 1, wherein the curing furnace (2) comprises a heating module (21) for heating and curing solar cells, and a waste discharge device (22) and a combustion tower (23) arranged on the top of the heating module (21); the heating module (21) is arranged on the rack (1), the top of the heating module (21) is provided with waste discharge ports, the combustion tower (23) and the waste discharge device (22) are respectively connected to different waste discharge ports, the heating module (21) has a heating chamber, the heating chamber comprises a plurality of unit heating chambers arranged side by side, the temperature of each of the unit heating chambers can be independently controlled, and the conveying device (4) passes through each of the unit heating chambers.

3. The solar cell curing and hydrogen passivation integrated machine according to claim 2, wherein the heating module (21) comprises an upper heating module (211) and a lower heating module (212), the upper heating module (211) and the lower heating module (212) are both arranged on the rack (1) in a manner of being able to be raised and lowered up and down.

4. The solar cell curing and hydrogen passivation integrated machine according to claim 1, wherein the conveying device (4) comprises a plurality of conveying rollers (41) rotatably arranged on the rack (1) and a driving device arranged on the rack (1) for driving the rotation of the conveying roller (41), and the plurality of the conveying rollers (41) is arranged in parallel, and the driving device comprises a transmission shaft (42) rotatably arranged on the rack (1), a driving wheel (43) fixedly arranged on the transmission shaft (42), and a driven wheel (44) fixedly arranged on one end portion of each of the conveying rollers (41), and a motor for driving the transmission shaft (42) to rotate, the driving device further comprises a transmission mechanism that is arranged between the driven wheel (44) and the driving wheel (43) and drives the driven wheel (44) to rotate when the driving wheel (43) rotates, and the transmission mechanism is a magnetic transmission mechanism, a belt transmission mechanism or a gear transmission mechanism.

5. The solar cell curing and hydrogen passivation integrated machine according to claim 1 or 6, wherein the conveying device (4) comprises a plurality of conveying rollers (41) rotatably arranged on the rack (1), each of the conveying rollers (41) is provided with a positioning structure for positioning solar cells at the same axial position, the positioning structure comprises a recess portion (411) arranged on each conveying roller (41) and two positioning portions (412) at two ends of the recess portion (411), and the solar cells are located in the recess portion (411), and are limited by the positioning portions (412) on their opposite sides.

6. The solar cell curing and hydrogen passivation integrated machine according to claim 1, wherein the integrated machine further comprises a third cooling device (5) arranged on the rack (1), the third cooling device (5) is arranged on the rack (1) close to the end portion of the hydrogen passivation furnace (3) in the outputting direction, the third cooling device (5) comprises a cooling box (51) arranged on the rack (1) and a cooling fan (52) arranged on the cooling box (51), the cooling box (51) has a cooling chamber, the conveying device (4) passes through the cooling chamber, the cooling box (51) is provided with an air inlet and an air outlet (511), the air inlet and the air outlet (511) are respectively located above and below the conveying device (4), the cooling fan (52) is arranged at the air inlet, the cooling box (51) is provided with a confluence area (512) with a tapered structure, and the air outlet (511) is arranged at a small end of the confluence area (512).

## Patentansprüche

1. Integrierte Maschine zum Aushärten und zur Wasserstoffpassivierung von Solarzellen, umfassend ein Gestell (1), einen Aushärteofen (2), der dazu ausgebildet ist, eine Aushärtebehandlung an Solarzellen durchzuführen, einen Wasserstoffpassivierungsofen (3), der dazu ausgebildet ist, eine Wasserstoffpassivierungsbehandlung an den Solarzellen durchzuführen, und eine Fördervorrichtung (4), die dazu ausgebildet ist, die Solarzellen zu fördern, wobei der Aushärteofen (2) und der Wasserstoffpassivierungsofen (3) nacheinander auf dem Gestell (1) angeordnet sind, wobei ein die Teile ausgebender Endabschnitt des Aushärteofens (2) an einen die Teile aufnehmenden Endabschnitt des Wasserstoffpassivierungsofens (3) angrenzt, wobei die Fördervorrichtung (4) durchgehend auf dem Gestell (1) angeordnet ist und die Fördervorrichtung (4) jeweils durch den Aushärteofen (2) und den Wasserstoffpassivierungsofen (3) hindurchgeht;
wobei der Wasserstoffpassivierungsofen (3) ein optisches Modul (31), ein elektrisches Modul (32) und ein Temperaturregelsystem (33) zum Regeln der Temperatur in dem Ofenhohlraum des Wasserstoffpassivierungsofens (3) umfasst; wobei das optische Modul (31), das elektrische Modul (32) und das Temperaturregelsystem (33) alle auf dem Gestell (1) angeordnet sind und das optische Modul (31) und das elektrische Modul (32) durch eine Leitung verbunden sind,
**dadurch gekennzeichnet, dass**
das Temperaturregelsystem (33) einen Steuerkasten (331), der auf dem Gestell (1) und an der Unterseite des optischen Moduls (31) angeordnet ist, eine in dem Steuerkasten (331) angeordnete Heizeinheit (332) und eine an dem Steuerkasten (331) angeordnete Kühleinheit (333) umfasst;
das optische Modul (31) einen auf dem Gestell (1) angeordneten Lichtquellenkasten (311), eine Mehrzahl von unabhängig steuerbaren Lichtquellenvorrichtungen, die an dem Lichtquellenkasten (311) angeordnet sind, und eine Mehrzahl von Sammellinsenvorrichtungen umfasst, welche die lichtemittierenden Flächen der Lichtquellenvorrichtungen von außen abdecken, wobei jede Lichtquellenvorrichtung mindestens eine Einheit an Lichtintensität bereitstellt;
das optische Modul (31) ferner eine erste Kühlvorrichtung zum Kühlen von lichtemittierenden Rückseiten der Lichtquellenvorrichtungen und/oder eine zweite Kühlvorrichtung zum Kühlen von lichtemittierenden Vorderseiten der Lichtquellenvorrichtungen umfasst, wobei die erste Kühlvorrichtung eine Wasserkühleinheit ist und die zweite Kühlvorrichtung eine Luftkühleinheit ist.

2. Integrierte Maschine zum Aushärten und zur Wasserstoffpassivierung von Solarzellen nach Anspruch 1, **dadurch gekennzeichnet, dass** der Aushärteofen (2) ein Heizmodul (21) zum Erwärmen und Aushärten von Solarzellen sowie eine Abfallabführvorrichtung (22) und einen Verbrennungsturm (23), die an der Oberseite des Heizmoduls (21) angeordnet sind, umfasst; wobei das Heizmodul (21) auf dem Gestell (1) angeordnet ist, die Oberseite des Heizmoduls (21) mit Abfallabführöffnungen versehen ist, der Verbrennungsturm (23) und die Abfallabführvorrichtung (22) jeweils mit unterschiedlichen Abfallabführöffnungen verbunden sind, das Heizmodul (21) eine Heizkammer aufweist, die Heizkammer eine Mehrzahl von nebeneinander angeordneten Einheitsheizkammern umfasst, die Temperatur jeder der Einheitsheizkammern unabhängig geregelt werden kann und die Fördervorrichtung (4) durch jede der Einheitsheizkammern hindurchgeht.

3. Integrierte Maschine zum Aushärten und zur Wasserstoffpassivierung von Solarzellen nach Anspruch 2, **dadurch gekennzeichnet, dass** das Heizmodul (21) ein oberes Heizmodul (211) und ein unteres Heizmodul (212) umfasst, wobei das obere Heizmodul (211) und das untere Heizmodul (212) beide derart auf dem Gestell (1) angeordnet sind, dass sie nach oben und nach unten angehoben und abgesenkt werden können.

4. Integrierte Maschine zum Aushärten und zur Wasserstoffpassivierung von Solarzellen nach Anspruch 1, **dadurch gekennzeichnet, dass** die Fördervorrichtung (4) eine Mehrzahl von drehbar auf dem Gestell (1) angeordneten Förderrollen (41) und eine auf dem Gestell (1) angeordnete Antriebsvorrichtung zum Antreiben der Drehung der Förderrolle (41) umfasst, wobei die Mehrzahl der Förderrollen (41) parallel angeordnet ist und die Antriebsvorrichtung eine drehbar auf dem Gestell (1) angeordnete Übertragungswelle (42), ein fest auf der Übertragungswelle (42) angeordnetes Antriebsrad (43) und ein fest an einem Endabschnitt jeder der Förderrollen (41) angeordnetes Abtriebsrad (44) sowie einen Motor zum Antreiben der Drehung der Übertragungswelle (42) umfasst, wobei die Antriebsvorrichtung ferner einen Übertragungsmechanismus umfasst, der zwischen dem Abtriebsrad (44) und dem Antriebsrad (43) angeordnet ist und das Abtriebsrad (44) zur Drehung antreibt, wenn sich das Antriebsrad (43) dreht, und wobei der Übertragungsmechanismus ein magnetischer Übertragungsmechanismus, ein Riemenübertragungsmechanismus oder ein Zahnradübertragungsmechanismus ist.

5. Integrierte Maschine zum Aushärten und zur Wasserstoffpassivierung von Solarzellen nach Anspruch 1 oder 6, **dadurch gekennzeichnet, dass** die Fördervorrichtung (4) eine Mehrzahl von drehbar auf dem Gestell (1) angeordneten Förderrollen (41) umfasst, wobei jede der Förderrollen (41) mit einer Positionierstruktur zum Positionieren von Solarzellen an derselben axialen Position versehen ist, wobei die Positionierstruktur einen an jeder Förderrolle (41) angeordneten Vertiefungsabschnitt (411) und zwei Positionierabschnitte (412) an beiden Enden des Vertiefungsabschnitts (411) umfasst, und wobei sich die Solarzellen in dem Vertiefungsabschnitt (411) befinden und an ihren einander gegenüberliegenden Seiten durch die Positionierabschnitte (412) begrenzt sind.

6. Integrierte Maschine zum Aushärten und zur Wasserstoffpassivierung von Solarzellen nach Anspruch 1, **dadurch gekennzeichnet, dass** die integrierte Maschine ferner eine auf dem Gestell (1) angeordnete dritte Kühlvorrichtung (5) umfasst, wobei die dritte Kühlvorrichtung (5) auf dem Gestell (1) nahe dem Endabschnitt des Wasserstoffpassivierungsofens (3) in Ausgaberichtung angeordnet ist, wobei die dritte Kühlvorrichtung (5) einen auf dem Gestell (1) angeordneten Kühlkasten (51) und einen an dem Kühlkasten (51) angeordneten Kühlventilator (52) umfasst, wobei der Kühlkasten (51) eine Kühlkammer aufweist, die Fördervorrichtung (4) durch die Kühlkammer hindurchgeht, der Kühlkasten (51) mit einem Lufteinlass und einem Luftauslass (511) versehen ist, wobei der Lufteinlass und der Luftauslass (511) jeweils oberhalb und unterhalb der Fördervorrichtung (4) angeordnet sind, der Kühlventilator (52) an dem Lufteinlass angeordnet ist, der Kühlkasten (51) mit einem Zusammenführungsbereich (512) von sich verjüngender Struktur versehen ist und der Luftauslass (511) an einem kleinen Ende des Zusammenführungsbereichs (512) angeordnet ist.

## Revendications

1. Machine intégrée de durcissement et de passivation à l'hydrogène de cellules solaires, comprenant un bâti (1), un four de durcissement (2) adapté pour effectuer un traitement de durcissement sur des cellules solaires, un four de passivation à l'hydrogène (3) adapté pour effectuer un traitement de passivation à l'hydrogène sur les cellules solaires, et un dispositif de convoyage (4) adapté pour convoyer les cellules solaires, le four de durcissement (2) et le four de passivation à l'hydrogène (3) étant agencés successivement sur le bâti (1), une partie d'extrémité de sortie des pièces du four de durcissement (2) étant adjacente à une partie d'extrémité d'entrée des pièces du four de passivation à l'hydrogène (3), le dispositif de convoyage (4) étant agencé de manière continue sur le bâti (1), et le dispositif de convoyage (4) traversant respectivement le four de durcissement (2) et le four de passivation à l'hydrogène (3) ;
le four de passivation à l'hydrogène (3) comprenant un module optique (31), un module électrique (32) et un système de régulation de température (33) destiné à réguler la température dans la cavité de four du four de passivation à l'hydrogène (3) ; le module optique (31), le module électrique (32) et le système de régulation de température (33) étant tous agencés sur le bâti (1), le module optique (31) et le module électrique (32) étant reliés par une ligne,
**caractérisée en ce que**,
le système de régulation de température (33) comprend un boîtier de commande (331) agencé sur le bâti (1) et situé à la partie inférieure du module optique (31), une unité de chauffage (332) agencée dans le boîtier de commande (331), et une unité de refroidissement (333) agencée sur le boîtier de commande (331) ;
le module optique (31) comprend un boîtier de source lumineuse (311) agencé sur le bâti (1), une pluralité de dispositifs de source lumineuse pouvant être commandés indépendamment et agencés sur le boîtier de source lumineuse (311), et une pluralité de dispositifs de lentille convergente recouvrant l'extérieur des surfaces d'émission de lumière des dispositifs de source lumineuse, et chaque dispositif de source lumineuse fournit au moins une unité d'intensité lumineuse ;
le module optique (31) comprend en outre un premier dispositif de refroidissement destiné à refroidir des faces arrière d'émission de lumière des dispositifs de source lumineuse et/ou un deuxième dispositif de refroidissement destiné à refroidir des faces avant d'émission de lumière des dispositifs de source lumineuse, le premier dispositif de refroidissement étant une unité de refroidissement à eau, et le deuxième dispositif de refroidissement étant une unité de refroidissement par air.

2. Machine intégrée de durcissement et de passivation à l'hydrogène de cellules solaires selon la revendication 1, **caractérisée en ce que** le four de durcissement (2) comprend un module de chauffage (21) destiné à chauffer et à durcir des cellules solaires, ainsi qu'un dispositif d'évacuation des déchets (22) et une tour de combustion (23) agencés au sommet du module de chauffage (21) ; le module de chauffage (21) est agencé sur le bâti (1), le sommet du module de chauffage (21) est pourvu d'orifices d'évacuation des déchets, la tour de combustion (23) et le dispositif d'évacuation des déchets (22) sont reliés respectivement à des orifices d'évacuation des déchets différents, le module de chauffage (21) présente une chambre de chauffage, la chambre de chauffage comprend une pluralité de chambres de chauffage unitaires agencées côte à côte, la température de chacune des chambres de chauffage unitaires peut être régulée indépendamment, et le dispositif de convoyage (4) traverse chacune des chambres de chauffage unitaires.

3. Machine intégrée de durcissement et de passivation à l'hydrogène de cellules solaires selon la revendication 2, **caractérisée en ce que** le module de chauffage (21) comprend un module de chauffage supérieur (211) et un module de chauffage inférieur (212), le module de chauffage supérieur (211) et le module de chauffage inférieur (212) étant tous deux agencés sur le bâti (1) de manière à pouvoir être montés et descendus vers le haut et vers le bas.

4. Machine intégrée de durcissement et de passivation à l'hydrogène de cellules solaires selon la revendication 1, **caractérisée en ce que** le dispositif de convoyage (4) comprend une pluralité de rouleaux de convoyage (41) agencés de manière rotative sur le bâti (1) et un dispositif d'entraînement agencé sur le bâti (1) et destiné à entraîner en rotation le rouleau de convoyage (41), et la pluralité des rouleaux de convoyage (41) est agencée en parallèle, et le dispositif d'entraînement comprend un arbre de transmission (42) agencé de manière rotative sur le bâti (1), une roue motrice (43) fixée sur l'arbre de transmission (42), et une roue menée (44) fixée sur une partie d'extrémité de chacun des rouleaux de convoyage (41), ainsi qu'un moteur destiné à entraîner en rotation l'arbre de transmission (42), le dispositif d'entraînement comprend en outre un mécanisme de transmission qui est agencé entre la roue menée (44) et la roue motrice (43) et qui entraîne la roue menée (44) en rotation lorsque la roue motrice (43) tourne, et le mécanisme de transmission est un mécanisme de transmission magnétique, un mécanisme de transmission à courroie ou un mécanisme de transmission à engrenages.

5. Machine intégrée de durcissement et de passivation à l'hydrogène de cellules solaires selon la revendication 1 ou 6, **caractérisée en ce que** le dispositif de convoyage (4) comprend une pluralité de rouleaux de convoyage (41) agencés de manière rotative sur le bâti (1), chacun des rouleaux de convoyage (41) est pourvu d'une structure de positionnement destinée à positionner des cellules solaires à une même position axiale, la structure de positionnement comprend une partie d'évidement (411) agencée sur chaque rouleau de convoyage (41) et deux parties de positionnement (412) situées aux deux extrémités de la partie d'évidement (411), et les cellules solaires sont situées dans la partie d'évidement (411) et sont limitées, sur leurs côtés opposés, par les parties de positionnement (412).

6. Machine intégrée de durcissement et de passivation à l'hydrogène de cellules solaires selon la revendication 1, **caractérisée en ce que** la machine intégrée comprend en outre un troisième dispositif de refroidissement (5) agencé sur le bâti (1), le troisième dispositif de refroidissement (5) est agencé sur le bâti (1) à proximité de la partie d'extrémité du four de passivation à l'hydrogène (3) dans la direction de sortie, le troisième dispositif de refroidissement (5) comprend un boîtier de refroidissement (51) agencé sur le bâti (1) et un ventilateur de refroidissement (52) agencé sur le boîtier de refroidissement (51), le boîtier de refroidissement (51) présente une chambre de refroidissement, le dispositif de convoyage (4) traverse la chambre de refroidissement, le boîtier de refroidissement (51) est pourvu d'une entrée d'air et d'une sortie d'air (511), l'entrée d'air et la sortie d'air (511) sont situées respectivement au-dessus et au-dessous du dispositif de convoyage (4), le ventilateur de refroidissement (52) est agencé au niveau de l'entrée d'air, le boîtier de refroidissement (51) est pourvu d'une zone de confluence (512) présentant une structure conique, et la sortie d'air (511) est agencée à une petite extrémité de la zone de confluence (512).
